(19)

Europäisches
Patentamt
European
Patent Office
Office européen
des brevets

(11) **EP 4 568 196 A1**

(12) **EUROPEAN PATENT APPLICATION**

(43) Date of publication:
**11.06.2025 Bulletin 2025/24**

(51) International Patent Classification (IPC):
*H04L 25/02* (2006.01)     *H03K 3/00* (2006.01)
*H04J 3/12* (2006.01)     *H04L 12/40* (2006.01)

(21) Application number: **24156391.5**

(22) Date of filing: **07.02.2024**

(52) Cooperative Patent Classification (CPC):
**H04L 25/0272; H04L 12/12; H04L 25/0292;**
H03K 3/35613; H03K 5/2481

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.12.2023 IN 202341082365**

(71) Applicant: **NXP B.V.**
**5656 AG Eindhoven (NL)**

(72) Inventors:
• **Sherigar, Arvind**
**5256AG Eindhoven (NL)**
• **Koushik, Susheel Madhusudan**
**5256AG Eindhoven (NL)**

(74) Representative: **Schmütz, Christian Klaus
Johannes
NXP Semiconductors Germany GmbH
Intellectual Property Group
Beiersdorfstr. 12
22529 Hamburg (DE)**

(54) **A DIFFERENTIAL INPUT RECEIVER AND A WAKE-UP RECEIVER**

(57)     A differential input receiver for detecting wake-up signalling in a differential communication system. The receiver has a first and a second diode connected FET. The source of the first diode connected FET is connected to a positive input signal terminal. The drain of the first diode connected FET is connected to a first current source. The gate of the first diode connected FET is connected to the first current source. The source of the second diode connected FET is connected to a negative input signal terminal. The drain of the second diode connected FET is connected to a second current source. The gate of the second diode connected FET is connected to the second current source. The receiver also included a first and a second cross differential FET. The source of the first cross differential FET is connected to the negative input signal terminal. The drain of the first cross differential FET is connected to a first output terminal. The gate of the first cross differential FET is connected to the gate of the first diode connected FET. The source of the second cross differential FET is connected to the positive input signal terminal. The drain of the second cross differential FET is connected to a second output terminal. The gate of the second cross differential FET is connected to the gate of the second diode connected FET.

Figure 1

FIG. 1

EP 4 568 196 A1

Description

Field

The present disclosure relates to a differential input receiver and a wake-up receiver, and in particular to such receivers for a CAN system.

Summary

According to a first aspect of the present disclosure there is provided a differential input receiver for detecting wake-up signalling in a differential communication system, the receiver comprising:

a positive input signal terminal for connecting to a positive bus of the differential communication system;
a negative input signal terminal, for connecting to a negative bus of the differential communication system;
a first output terminal;
a second output terminal;
a first current source;
a second current source;
a first diode connected field-effect-transistor, FET, having a source, a drain and a gate, wherein

the source of the first diode connected FET is connected to the positive input signal terminal,
the drain of the first diode connected FET is connected to the first current source, and
the gate of the first diode connected FET is connected to the first current source;

a second diode connected FET, having a source, a drain and a gate, wherein

the source of the second diode connected FET is connected to the negative input signal terminal,
the drain of the second diode connected FET is connected to the second current source, and
the gate of the second diode connected FET is connected to the second current source;

a first cross differential FET, having a source, a drain and a gate, wherein

the source of the first cross differential FET is connected to the negative input signal terminal, and
the drain of the first cross differential FET is connected to the first output terminal,

the gate of the first cross differential FET is connected to the gate of the first diode connected FET; and
a second cross differential FET, having a source, a drain and a gate, wherein

the source of the second cross differential FET is connected to the positive input signal terminal, and
the drain of the second cross differential FET is connected to the second output terminal,

the gate of the second cross differential FET is connected to the gate of the second diode connected FET.

In one or more embodiments:

the first diode connected FET is an n-type metal-oxide-semiconductor, NMOS, FET;
the second diode connected FET is an NMOS FET;
the first cross differential FET is an NMOS FET; and
the second cross differential FET is an NMOS FET.

In one or more embodiments, the differential input receiver further comprises:

a first upper voltage divider resistor with a first terminal connected to the positive input signal terminal and a second terminal connected to the source of the second cross differential FET and the source of the first diode connected FET;
a first lower voltage divider resistor with a first terminal connected to the second terminal of the first upper voltage divider resistor and a second terminal connected to a ground terminal;
a second upper voltage divider resistor with a first terminal connected to the negative input signal terminal and a second terminal connected to the source of the first cross differential FET and the source of the second diode connected FET; and

a second lower voltage divider resistor with a first terminal connected to the second terminal of the second upper voltage divider resistor and a second terminal connected to the ground terminal.

In one or more embodiments:

the first upper voltage divider resistor has a resistance greater than the resistance of the first lower voltage divider resistor; and
the second upper voltage divider resistor has a resistance much greater than the resistance of the second lower voltage divider resistor.

In one or more embodiments, the differential input receiver further comprises:

a first capacitor having a first plate and a second plate, wherein: the first plate is connected to the second terminal of the first upper voltage divider resistor; and the second plate is connected to the ground terminal; and
a second capacitor having a first plate and a second plate, wherein: the first plate is connected to the second terminal of the second upper voltage divider resistor; and the second plate is connected to the ground terminal.

In one or more embodiments, the differential input receiver further comprises a threshold resistor connected between either:

i) the second terminal of the first upper voltage divider resistor, and ii) the source of the first diode connected FET and the source of the second cross differential FET; or
i) the second terminal of the second upper voltage divider resistor, and ii) the source of the second diode connected FET and the source of the first cross differential FET.

In one or more embodiments, the differential input receiver further comprises a threshold setting current source configured to provide a current to a node between either:

the second terminal of the first upper voltage divider resistor and the first threshold resistor, if
the first threshold resistor is connected between the second terminal of the first upper voltage divider resistor and the source of the first diode connected FET and the source of the second cross differential FET; or
the first threshold resistor and the source of the first cross differential FET and the source of the second diode connected FET, if
the first threshold resistor is connected between the second terminal of the second upper voltage divider resistor and the source of the second diode connected FET and the source of the first cross differential FET.

In one or more embodiments, the differential input receiver further comprises:

a first threshold resistor connected between: i) the second terminal of the first upper voltage divider resistor; and ii) the source of the first diode connected FET and the source of the second cross differential FET;
a second threshold resistor connected between: i) the second terminal of the second upper voltage divider resistor; and ii) the source of the second diode connected FET and the source of the first cross differential FET;
a first threshold setting current source configured to provide a current to a node between the first upper voltage divider resistor and the first threshold resistor; and
a second threshold setting current source configured to provide a current to a node between the second threshold resistor and the and the source of the second diode connected FET.

In one or more embodiments, the differential input receiver further comprises:

a cascode voltage source;
a first cascode FET having a source, gate and drain, wherein:

the source of the first cascode FET is connected to the drain of the first cross differential FET,
the drain of the first cascode FET is connected to the first output terminal, and
the gate of the first cascode FET is connected to a first cascode voltage source; and

a second cascode FET having a source, gate and drain, wherein:

the source of the second cascode FET is connected to the drain of the second cross differential FET,
the drain of the second cascode FET is connected to the second output terminal, and
the gate of the second cascode FET is connected to a second cascode voltage source.

In one or more embodiments:

the first cascode FET is an NMOS FET; and
the second cascode FET is an NMOS FET.

In one or more embodiments, the differential input receiver further comprises:

a first folded cascode current source ;
a second folded cascode current source;
a folded cascode voltage source;
a first folded cascode FET and a second folded cascode FET, each having a source, drain and a gate, wherein:

the source of the first folded cascode FET is connected to: i) the drain of the second cross differential FET; and ii) the first folded cascode current source;
the drain of the first folded cascode FET is connected to the second output terminal;
the gate of the first folded cascode FET is connected to the gate of the first folded cascode FET;
the source of the second folded cascode FET is connected to: i) the drain of the first cross differential FET; and ii) the second folded cascode current source;

the drain of the second folded cascode FET is connected to the first output terminal.

In one or more embodiments, the differential input receiver further comprises:

a first sink FET, having a source, drain and a gate, wherein:

the source of the first sink FET is connected to a ground terminal; and
the drain of the first sink FET is connected to the second output terminal and the drain of the third cascode FET;

a second sink FET, having a source, drain and a gate, wherein:

the source of the second sink FET is connected to the ground terminal;
the drain of the second sink FET is connected to the first output terminal and the drain of the fourth cascode FET; and
the gate of the second sink FET is connected to the gate of the first sink FET.

a first differential gain resistor connected between: i) the second output terminal; and ii) the gate of the second sink FET and the gate of the first sink FET; and
a second differential gain resistor connected between: i) the first output terminal; and ii) the gate of the second sink FET and the gate of the first sink FET.

In one or more embodiments:

the first folded cascode FET is a PMOS FET;
the second folded cascode FET is a PMOS FET;
the first sink FET is an NMOS FET; and
the second sink FET is an NMOS FET.

There is also disclosed a wake-up receiver comprising:

any differential input receiver disclosed herein;
a wake-up receiver output terminal; and
a comparator comprising a first input terminal, a second input terminal and an output terminal, wherein:

the first input terminal of the comparator is connected to the second output terminal of the differential input receiver,

the second input terminal of the comparator is connected to the first output terminal of the differential input receiver, and

the output terminal of the comparator is connected to the wake-up receiver output terminal.

In one or more embodiments, the wake-up receiver further comprises an additional gain stage comprising:

a first input terminal,
a second input terminal,
a first output terminal, and
a second output terminal, wherein:

the first input terminal of the additional gain stage is connected to the second output terminal of the differential input receiver,

the second input terminal of the additional gain stage is connected to the first output terminal of the differential input receiver,

the first output terminal of the additional gain stage is connected to the first input terminal of the comparator, and

the second output terminal of the additional gain stage is connected to the second input terminal of the comparator.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## **Brief Description of the Drawings**

One or more embodiments will now be described by way of example only with reference to the accompanying drawings in which:

Figure 1 shows an example embodiment of a wake-up receiver for a CAN system according to an aspect of the present disclosure;

Figure 2 shows three histograms that illustrate performance of the circuit of Figure 1 at different temperatures;

Figure 3 shows a plot of signals that illustrate the transient DPI performance of the circuit of Figure 1; and

Figure 4 shows another plot of signals during operation of the circuit of Figure 1.

## **Detailed Description**

Examples disclosed herein address supply headroom limitations of a wake-up receiver (WURX) at low supply voltages. They can also provide excellent electromagnetic compatibility (EMC) immunity, speed and low quiescent current consumption.

The present disclosure relates to differential communication systems, such as CAN (Controller Area Network) systems. It is known for CAN systems to be used in automobiles, which is an environment where a reasonable amount of noise can be present.

A wake-up receiver (WURX) is a low power circuit that is intended to detect a wake-up pattern or tone on a bus when a main analogue supply voltage (VCC) is off for power saving. Therefore, the current consumption of the WURX should be low.

In the examples disclosed herein, wake-up signalling is provided as a differential signal on a bus with a defined amplitude and frequency. The wake-up signalling on the bus can be present amidst high RF (radio frequency) common mode DPI (direct power injection); which can be as much as 25 V to 40 V, at frequencies in excess of 1 MHz. However, the supply voltage for the wake-up receiver is much smaller than the DPI noise amplitudes.

A resistive divider with a large division ratio can be used to provide a voltage signal for wake-up detection that is much lower than the voltage level on the bus. This can assist with high DPI and supply headroom requirements. Additionally, BJT (bipolar junction transistor) and diode-based class A differential comparators can be used to reject common mode noise and detect a wake-up.

However, if the voltage supply for the WURX is as low as 1.8 V (nominal), then this can pose a challenge to known implementations of a WURX. This is because use of BJTs and diodes in the known architectures can have a minimum supply requirement of 2.4 V. One or more of the examples disclosed herein can enable wake-up detection at low power supply and high common mode.

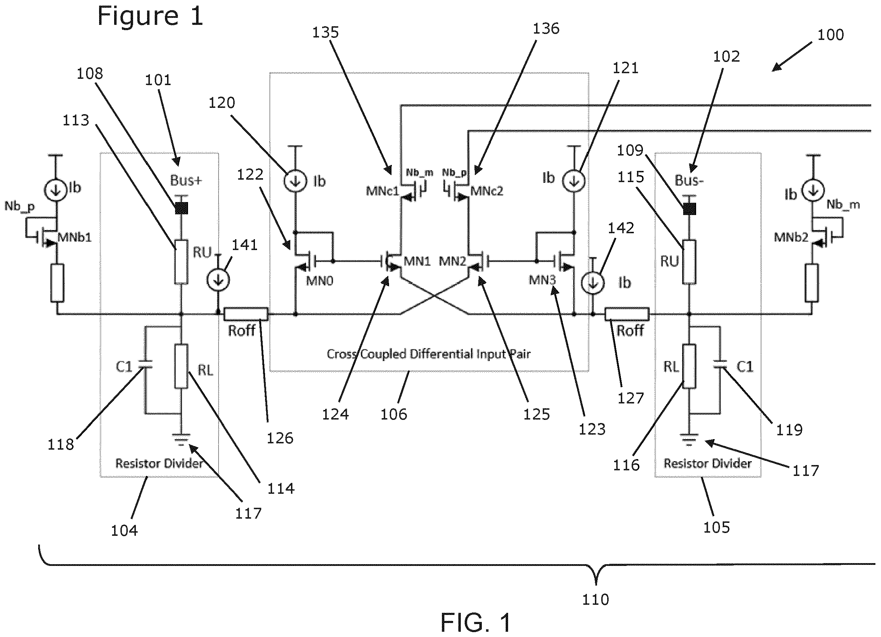

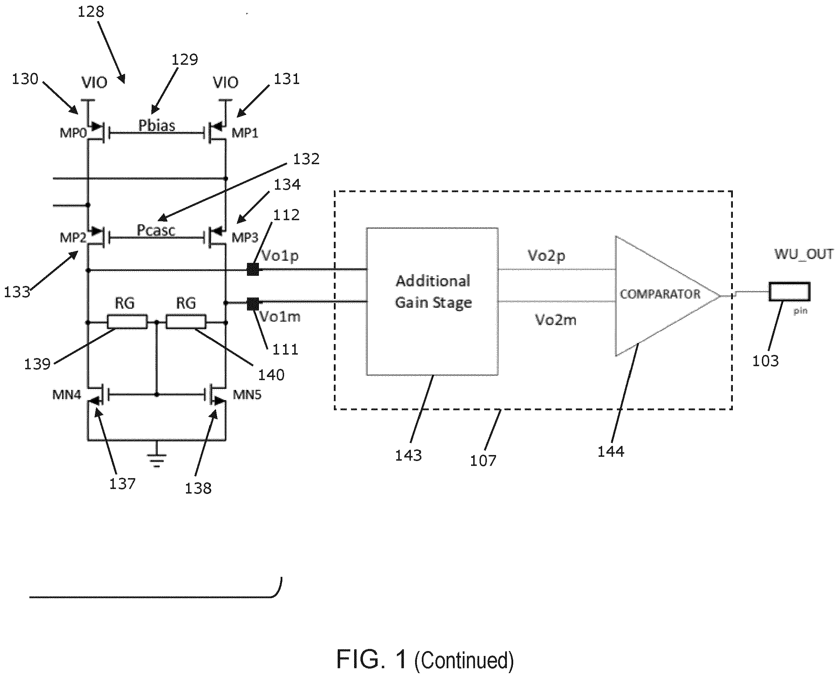

Figure 1 shows an example embodiment of a wake-up receiver 100 for a CAN system according to an aspect of the present disclosure. The CAN system is an example of a differential communication system, which has a positive bus (Bus+) 101 and a negative bus (Bus-) 102.

The wake-up receiver 100 has a wake-up receiver output terminal 103, which provides a wake-up receiver output signal.

As will be discussed in detail below, the wake-up receiver 100 includes:

- a first resistive divider 104 and a second resistive divider 105;
- a cross-coupled differential amplifier 106 as an input stage; and
- a pre-amplifier and a comparator 107.

The first resistive divider 104, the second resistive divider 105 and the cross-coupled differential amplifier 106 can together be considered as a differential input receiver 110. The differential input receiver 110 has:

a positive input signal terminal 108, for connecting to the positive bus (Bus+) 101;
a negative input signal terminal 109, for connecting to the negative bus (Bus-);
a first output terminal 111; and
a second output terminal 112.

The pre-amplifier and the comparator 107 are connected to the first and second output terminals 111, 112 of the differential input receiver 110.

Turning now to the differential input receiver 110 in more detail, the first resistive divider 104 is connected to the positive bus (Bus+) 101. It is used to attenuate the common mode voltages on the positive bus (Bus+) 101 to acceptable levels such that the output voltage of the first resistive divider 104 can be used for signal processing by the downstream components of the wake-up receiver 100. Similarly, the second resistive divider 105 is connected to the negative bus (Bus-) 102.

The first resistive divider 104 includes a first upper voltage divider resistor (RU) 113 and a first lower voltage divider resistor (RL) 114. The first upper voltage divider resistor (RU) 113 has: a first terminal, which is connected to the positive input signal terminal 108; and a second terminal, which is connected to the cross-coupled differential amplifier 106 (as will be discussed below). The first lower voltage divider resistor (RL) 114 has: a first terminal, which is connected to the second terminal of the first upper voltage divider resistor (RU) 113; and a second terminal, which is connected to a ground terminal 117.

The second resistive divider 105 includes a second upper voltage divider resistor (RU) 115 and a second lower voltage divider resistor (RL) 116. The second upper voltage divider resistor (RU) 115 has: a first terminal, which is connected to the negative input signal terminal 109; and a second terminal, which is connected to the cross-coupled differential amplifier 106 (as will be discussed below). The second lower voltage divider resistor (RL) 116 has: a first terminal, which is connected to the second terminal of the second upper voltage divider resistor (RU) 115; and a second terminal, which is connected to the ground terminal 117.

Each of the first and second upper voltage divider resistors (RU) 113, 115 has a resistance value that is greater than the resistance value of its associated lower voltage divider resistor (RL) 114, 116. For example, the resistance of an upper voltage divider resistor (RU) 113, 115 may be an order of magnitude greater than the resistance of its associated lower voltage divider resistor (RL) 114, 116. It will be appreciated that the ratio of RU/RL defines the division ratio of the BUS signal for DPI common mode management.

In this example, the first resistive divider 104 also includes a first capacitor 118. The first capacitor 118 has a first plate and a second plate. The first plate is connected to the second terminal of the first upper voltage divider resistor (RU) 113. The second plate is connected to the ground terminal 117. In this way, the first capacitor 118 is connected in parallel with the first lower voltage divider resistor (RL) 114.

Similarly, the second resistive divider 105 includes a second capacitor 119. The second capacitor has a first plate and a second plate. The first plate is connected to the second terminal of the second upper voltage divider resistor (RU) 115. The second plate is connected to the ground terminal 117. In this way, the second capacitor 119 is connected in parallel with the second lower voltage divider resistor (RL) 116.

For each of the first and second resistive dividers, the combination of the lower voltage divider resistor (RL) 114, 116 RL and the associated capacitor 118, 119 form the pole of a low pass filter. This will act to filter out higher frequency noise components, and is used to set the bandwidth of the system as per the specification of the application.

The cross-coupled differential amplifier 106 (which can also be considered as the input stage of the wake-up receiver 100) takes the divided differential bus inputs (output of the resistor dividers 104, 105) and is intended to apply a gain to the differential signal while rejecting all the common mode noise that may be present in the signal. This is done so that reliable wake-up detection can be made when a valid wake-up signal is transmitted on the bus.

In this example, the wake-up pattern or tone on the bus is a differential signal with a small but defined amplitude (e.g., about 0.5 V) and frequency. The bus however can have a frequency dependant common mode noise (due to DPI) which can be as high as $\pm 40$ V. The voltage supply for the wake-up receiver, however, would be much smaller. Therefore, to reliably detect a valid wake-up, the common mode should be processed by circuit components while detecting the differential component. Hence, the voltage supply level can become a critical parameter as a low supply voltage implies a limitation on the input common mode that the wake-up receiver can process. As will be discussed below, advantageously, examples of the cross-coupled differential amplifier 106 of the present disclosure provide a new way of processing the wake-up signal using a low supply voltage, even in the presence of high RF common mode. This can be achieved by using a cross-coupled differential amplifier 106 as the input stage.

As we will now describe in detail, the cross-coupled differential amplifier 106 in this example includes a number of current sources and field effect transistors (FETs) in order to implement a cross-coupled differential amplifier. Each of the FETs disclosed herein has a source, a drain and a gate.

The cross-coupled differential amplifier 106 includes a first current source 120 and a second current source 121.

The cross-coupled differential amplifier 106 also includes a first diode connected FET 122 and a second diode connected FET 123. The source of the first diode connected FET 122 is connected to the positive input signal terminal 108. In this example, as can be seen in Figure 1, the source of the first diode connected FET 122 is indirectly connected to the positive input signal terminal 108, in that two resistors are connected in series between the source of the first diode connected FET 122 and the positive input signal terminal 108. One of these resistors is the first upper voltage divider resistor (RU) 113 that is described above. The other resistor is an optional first threshold resistor (Roff) 126 that will be described below.

The drain of the first diode connected FET 122 is connected to the first current source 120. In this way, the first current source 120 is connected in series between: i) the drain of the first diode connected FET 122; and ii) a voltage supply terminal. The gate of the first diode connected FET 122 is also connected to the first current source 120, such that the gate and the drain of the first diode connected FET 122 are directly connected to each other. That is, there are no components connected between the gate and the drain of the first diode connected FET 122. In this way, the first diode connected FET 122 is provided as a diode connected transistor.

The source of the second diode connected FET 123 is connected to the negative input signal terminal 109. In a similar way to the source of the first diode connected FET 122, the source of the second diode connected FET 123 is indirectly connected to the negative input signal terminal 109. The drain of the second diode connected FET 123 is connected to the second current source 121. In this way, the second current source 121 is connected in series between: i) the drain of the second diode connected FET 123; and ii) a voltage supply terminal. The gate of the second diode connected FET 123 is also connected to the second current source 121, such that the gate and the drain of the second diode connected FET 123 are directly connected to each other in this example. Therefore, the second diode connected FET 123 is also provided as a diode connected transistor.

The cross-coupled differential amplifier 106 also includes a first cross differential FET 124 and a second cross differential FET 125. The source of the first cross differential FET 124 is connected to the negative input signal terminal 109. In this example, it is indirectly connected to the negative input signal terminal 109 via two resistors: the second upper voltage divider resistor (PU) 115, which is described above; and an optional second threshold resistor (Roff) 127, which will be described below. In this way, the source of the first cross differential FET 124 is also connected to the source of the second diode connected FET 123.

The drain of the first cross differential FET 124 is connected to the first output terminal 111. In this example, the drain of the first cross differential FET 124 is indirectly connected to the first output terminal 111 via various components, as will be discussed below. The gate of the first cross differential FET 124 is connected to the gate of the first diode connected FET 122.

The source of the second cross differential FET 125 is connected to the positive input signal terminal 108. In this example, it is indirectly connected to the positive input signal terminal 108 via two resistors: the first upper voltage divider resistor (RU) 113, which is described above; and an optional first threshold resistor (Roff) 126, which will be described below.

The drain of the second cross differential FET 125 is connected to the second output terminal 112. In this example, the drain of the second cross differential FET 125 is indirectly connected to the second output terminal 112 via various components, as will be discussed below. The gate of the second cross differential FET 125 is connected to the gate of the second diode connected FET 123.

In this example, each of the first and second diode connected FETs 122,123 and the first and second cross differential FETs 124, 125 is an n-type metal-oxide-semiconductor (NMOS) FET.

As indicated above, to process high RF common mode signals, the differential bus inputs are divided using the resistor dividers. This will reduce the high common mode level to lower than the supply voltage. This, however, means that the differential signal riding on the RF common mode is also heavily attenuated. In order to address this big disadvantage of signal attenuation, the cross-coupled differential amplifier 106 should have sufficient gain before providing output signals to the pre-amplifier and the comparator 107. The gain of the cross-coupled differential amplifier 106 depends on the transconductance (gm) of the input stage and the output impedance of the stage. A higher gain implies a requirement for higher gm, which translates to a requirement for higher current consumption. However, the cross-coupled differential amplifier 106 of Figure 1 advantageously provides a way of generating high gain at lower current consumption.

In Figure 1, the first cross differential FET 124 and the second cross differential FET 125 form an nmos differential pair of the amplifier in a common gate configuration. The first cross differential FET 124 and the second cross differential FET 125 are biased at their gates by the nmos first current source FET 122 and the nmos second current source FET 123, respectively. The nmos first and second diode connected FETs 122, 123 are provided as diode connected transistors, as described above, each using a constant current source 120, 121.

The divided bus signals (provided by the resistive dividers 104, 105) are provided as the differential input signals to the differential pair that is defined by the first and second cross differential FETs 124, 125. As discussed above, these FETs are cross-coupled; i.e., the divided Bus+ signal is provided to the conduction channel of the second cross differential FET 125, but the gate bias for the second cross differential FET 125 is derived from the divided Bus- signal. Similarly, the divided Bus- signal is provided to the conduction channel of the first cross differential FET 124, but the gate bias for the first cross differential FET 124 is derived from the divided Bus+ signal. The effect of this cross-coupling yields twice the transconductance in the differential pair because the entire signal swing is now available to the differential pair, as opposed to half the swing which is obtained without cross coupling. Hence for the same current consumption, the transconductance is doubled ($gm_{eff}$), yielding higher gain in the amplifier stage.

The differential current generated on the drains of the first and second cross differential FETs 124, 125 ($gm_{eff}*\Delta Vin$) is provided to a folded cascode output stage 128.

The folded cascode output stage 128 includes a first folded cascode current source (MP0) 130 and a second folded cascode current source (MP1) 131. The folded cascode output stage 128 also includes a folded cascode voltage source (Pcasc) 132, a first folded cascode FET (MP2) 133 and a second folded cascode FET (MP3) 134. The source of the first folded cascode FET (MP2) 133 is connected to: i) the drain of the second cross differential FET 125 (optionally via a second cascode FET 136, as will be discussed below); and ii) the first folded cascode current source (MP0). The drain of the first folded cascode FET (MP2) 133 is connected to the second output terminal 112. The gate of the first folded cascode FET (MP2) 133 is connected to the gate of the first folded cascode FET (MP3) 134. The source of the second folded cascode FET (MP3) 134 is connected to: i) the drain of the first cross differential FET 124 (optionally via a first cascode FET, as will be discussed below); and ii) the second folded cascode current source (MP1) 131. The drain of the second folded cascode FET (MP3) 134 is connected to the first output terminal 111.

The folded cascode output stage 128 also includes a first sink FET 137 and a second sink FET 138. The source of the first sink FET is connected to the ground terminal. The drain of the first sink FET 137 is connected to: i) the second output terminal 112; and also to the drain of the first folded cascode FET (MP2) 133. The source of the second sink FET 138 is connected to the ground terminal. The drain of the second sink FET 138 is connected to: the first output terminal 111; and also to the drain of the second folded cascode FET (MP3) 134. The gate of the second sink FET 138 is connected to the gate of the first sink FET 137.

In this example: the first and second folded cascode FETs 133, 134 are p-type metal-oxide-semiconductor (PMOS) FETs; and the first and second sink FETs 137, 138 are NMOS FETs.

As shown in Figure 1, the folded cascode output stage 128 also includes a first differential gain resistor 139 and a second differential gain resistor 140. The first differential gain resistor 139 is connected between: i) the second output terminal 112; and ii) the gate of the second sink FET 138 and the gate of the first sink FET 137 (which, as discussed above, as connected together). The second differential gain resistor 140 is connected between: i) the first output terminal 111; and ii) the gate of the second sink FET 138 and the gate of the first sink FET 137 (which, as discussed above, as connected together). In this way, the first and the second differential gain resistors 139, 140 are connected in series with each other between the first and second output terminals 111, 112. A circuit node is located at the connection between the first differential gain resistor 139 and the second differential gain resistor 140. This circuit node is connected to the gate of the first and second sink FETs 137, 138 in order to bias them.

The first and second folded cascode current sources (MP0, MP1) 130, 131 in this example are biased PMOS current sources, which accommodate the differential input current demanded by the first and second cross differential FETs 124, 125. The first and second folded cascode FETs (MP2, MP3) 133, 134 are PMOS cascode transistors which contain the differential current information, which when dropped across the differential gain resistors (RG) 139, 140 provides the voltage differential gain. The first and second sink FETs 137, 138 are nmos sink transistors which are self biased, with a bias voltage that is derived from the common mode midpoint of the differential gain resistors (RG) 139, 140.

The differential input receiver 110 further includes a first cascode FET 135 and a second cascode FET 136. The source of the first cascode FET 135 is connected to the drain of the first cross differential FET 124. The drain of the first cascode FET 135 is connected to the first output terminal 111, in this example via the folded cascode output stage 128. The source of the second cascode FET 136 is connected to the drain of the second cross differential FET 125. The drain of the second cascode FET 136 is connected to the second output terminal 112, in this example via the folded cascode output stage 128. The first and second cascode FETs 135, 136 are a NMOS FETs.

The gate of the first cascode FET 135 is connected to a first cascode voltage source (Nb_m). The gate of the second cascode FET 136 is connected to a second cascode voltage source (Nb_p). The first and second cascode voltage sources (Nb_m, Nb_p) are for biasing the first and second cascode FETs 135, 136. Advantageously, the voltage levels of the first and second cascode voltage sources (Nb_m, Nb_p) in this example are derived adaptively from the differential input receiver 110. That is, they are derived from the output of the resistive dividers associated with the Bus inputs, as shown in Figure 1. This enables the drain-source voltages of the first and second cross differential FETs 124, 125 to track variations in the input common mode.

The first and second cascode FETs 135, 136 are nmos cascode transistors for over-voltage protection of the first and second cross differential FETs 124, 125 respectively, when the supply level is higher than $Vds_{\max\_MN1} + V_{on\_MP0}$. By employing the first and second cascode FETs 135, 136, the wake-up receiver 100 can support a wide range of supply voltages. If it is not necessary for the wake-up receiver 100 to support a wide range of supply voltages, then the first and second cascode FETs 135, 136 can be omitted.

The wake-up receiver 100 can utilise a voltage threshold level in order to detect whether or not a differential wake-up tone / pattern is present on the bus. As we will now describe, the threshold level of the wake-up receiver 100 can be set conveniently using one or two threshold setting current sources 141, 142, each with an associated threshold resistor (Roff) 126, 127, in series with one of the inputs. Hence, one of the divided Bus signals (either Bus+ or Bus-) is greater than the other. For instance, if a threshold setting current source 142 and an associated threshold resistor (Roff) 127 is associated with the Bus-signal (and there is no first threshold setting current source 141 and associated threshold resistor (Roff) 126 associated with the Bus+ signal), then the divided Bus+ signal will be greater than the divided Bus- signal plus Ib*Roff. This effectively results in the application of a threshold.

In further detail, the differential input receiver 110 can include one or both of:

- a first threshold resistor 126 and a first threshold setting current source 141. The first threshold resistor 126 is connected between: i) the second terminal of the first upper voltage divider resistor 113; and ii) the source of the first diode connected FET 122 and the source of the second cross differential FET 125. The first threshold setting current source 141 provides a current to a node between the first upper voltage divider resistor 113 and the first threshold resistor 126.

- a second threshold resistor 127 and a second threshold setting current source 142. The second threshold resistor 127 is connected between: i) the second terminal of the second upper voltage divider resistor 115; and ii) the source of the second diode connected FET 123 and the source of the first cross differential FET 124. The second threshold setting current source is configured to provide a current to a node between the second threshold resistor 127 and the source of the second diode connected FET 123.

The advantages of doubling the transconductance, as is achieved by the circuit of Figure 1 as discussed above, include:

- Increasing the gain of the amplifier for the same current. Hence, it can be made low-power based on signal swing.
- Doubling the gm translates to halving the standard deviation for mismatch. This is a significant advantage, especially if such an improvement results in a subsequent trimming operation not being required.
- Same with reduction in noise.

**Explanation of how doubling the transconductance halves the standard deviation in mismatch**

We know that the drain current equation of a MOSFET in saturation region is given by:

$$Id = \frac{\beta}{2} * (Vgs - Vt)^2$$

Where

$$\beta = \mu_n C_{ox} W/L$$

and

$$gm = 2 \frac{Id}{(Vgs - Vt)}$$

To find the various contributions for current change due to mismatch:

-

$$\Delta I_d = \Delta \beta * \frac{(Vgs - Vt)^2}{2} + \frac{\beta}{2} * 2(Vgs - Vt) \Delta Vgs - \frac{\beta}{2} * 2(Vgs - Vt) \Delta Vt$$

- For diff pair $\Delta I_d = 0$

- Hence: $\frac{\beta}{2} * 2(Vgs - Vt) \Delta Vgs = - \Delta \beta * \frac{(Vgs - Vt)^2}{2} + \frac{\beta}{2} * 2(Vgs - Vt) \Delta Vt$

- Divide by $\beta * (Vgs - Vt)$ , we get:

-

$$\Delta Vgs = - \frac{\Delta \beta}{\beta} \frac{(Vgs - Vt)}{2} + \Delta Vt$$

$$\rightarrow \quad \Delta Vgs = - \frac{\Delta \beta}{\beta} * \frac{I_d}{gm} + \Delta Vt$$

It can be seen from the above equation that $\Delta Vgs$ is inversely proportional to gm. Hence, doubling gm results in mismatch sigma (i.e., standard deviation) in Vgs halving for the differential pair. This is a very important result because, by introducing the cross-coupling of Figure 1, we not only achieve higher gain for the same current but also, due to halving of standard deviation, the design has the potential to not require trimming.

## Preamplifier and Comparator

As discussed above, the common mode signal appearing on the bus will be rejected by the differential input pair, and the differential voltage gain will appear across the two ends of the differential gain resistors (PG) 139, 140.

In this example, the wake-up receiver 100 includes a simple preamplifier 143 to process this gained signal in order to amplify and condition the signal further, before providing it to a simple comparator 144 for rail to rail wake-detect output.

The comparator 144 has a first input terminal, a second input terminal and an output terminal. The first input terminal of the comparator 144 is connected to the second output terminal 122 of the differential input receiver 110 (in this example via the preamplifier 143). The second input terminal of the comparator 144 is connected to the first output terminal 111 of the differential input receiver 110 (in this example, also via the preamplifier 143). The output terminal of the comparator 144 is connected to the wake-up receiver output terminal 103. In this example, the comparator is a high gain comparator.

The preamplifier 143 can also be considered as an additional gain stage. The additional gain stage 143 has a first input terminal, a second input terminal, a first output terminal, and a second output terminal. The first input terminal of the additional gain stage 143 is connected to the second output terminal 112 of the differential input receiver 110. The second input terminal of the additional gain stage 143 is connected to the first output terminal 111 of the differential input receiver 110. The first output terminal of the additional gain stage 143 is connected to the first input terminal of the comparator 144. The second output terminal of the additional gain stage 143 is connected to the second input terminal of the comparator 144.

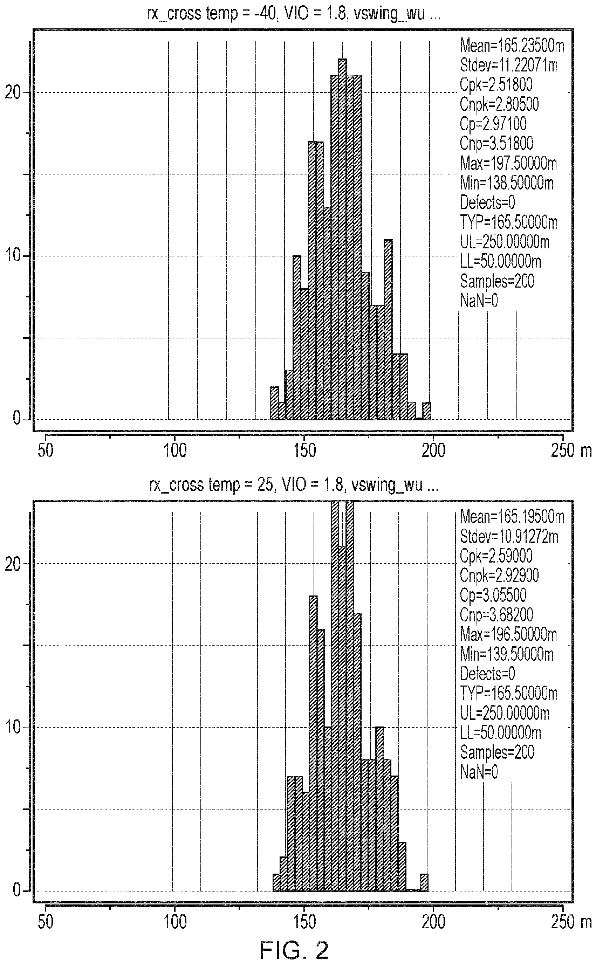

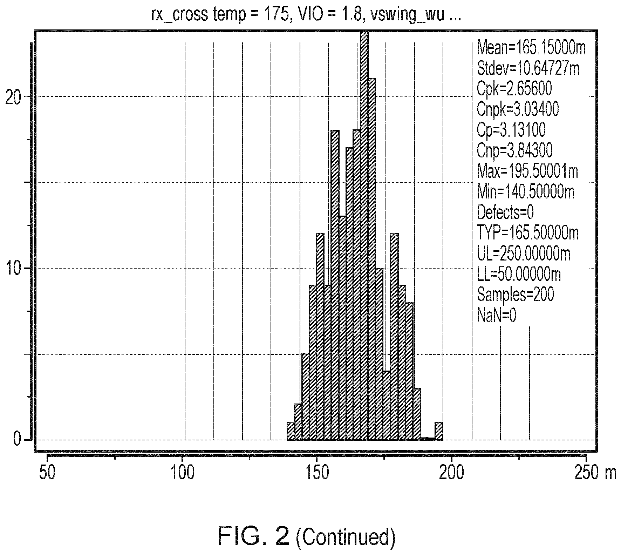

Figure 2 shows three histograms that illustrate performance of the circuit of Figure 1 at different temperatures. The horizontal axis of each histogram represents mismatch threshold voltage in millivolts. The vertical axis represents the number of samples. The histograms show mismatch threshold simulations at 1.8V supply and high common mode of 25 V, and at three different temperatures (-40C, 25C and 175C). As can be seen, the standard deviation (1 sigma) of the threshold across mismatch is ~ 11.2 mV, which is lower than would be the case without the cross-coupled amplifier of Figure 1. Beneficially, this does not necessitate trimming for a wake detect application.

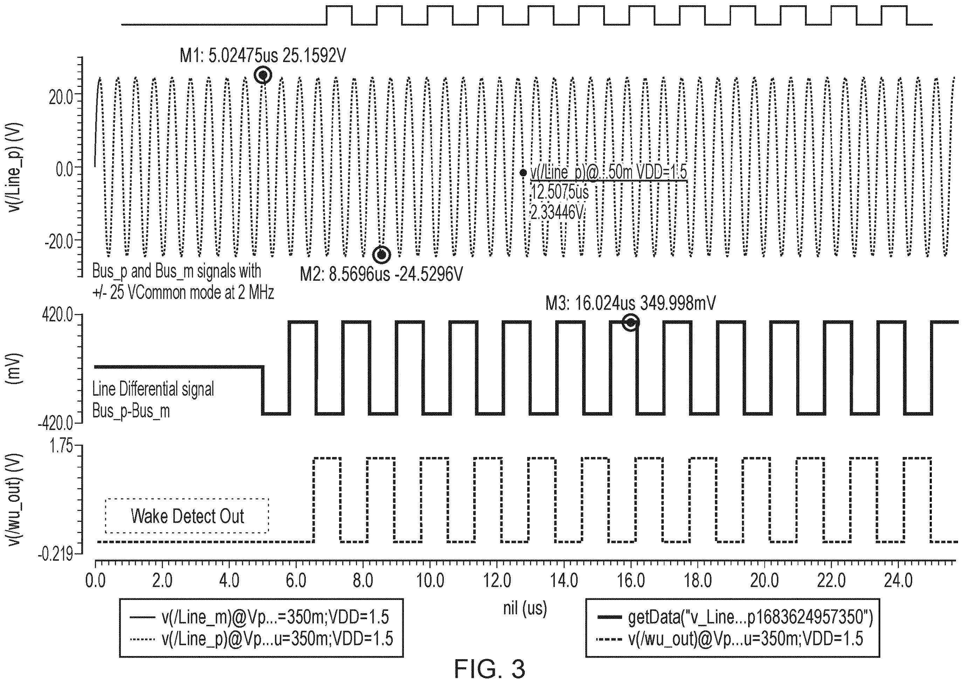

Figure 3 shows a plot of signals that illustrate the transient DPI performance of the circuit of Figure 1. The upper plot shows the RF noise. The middle plot shows the differential signal is present on the bus. The lower plot shows the output signal of the wake-up receiver. In this example, the bus has a differential signal of 350 mV (the middle plot) riding on RF common mode DPI of +/- 25 V; the upper plot). The lower plot shows the wake-detect output detecting every wake-up pulse.

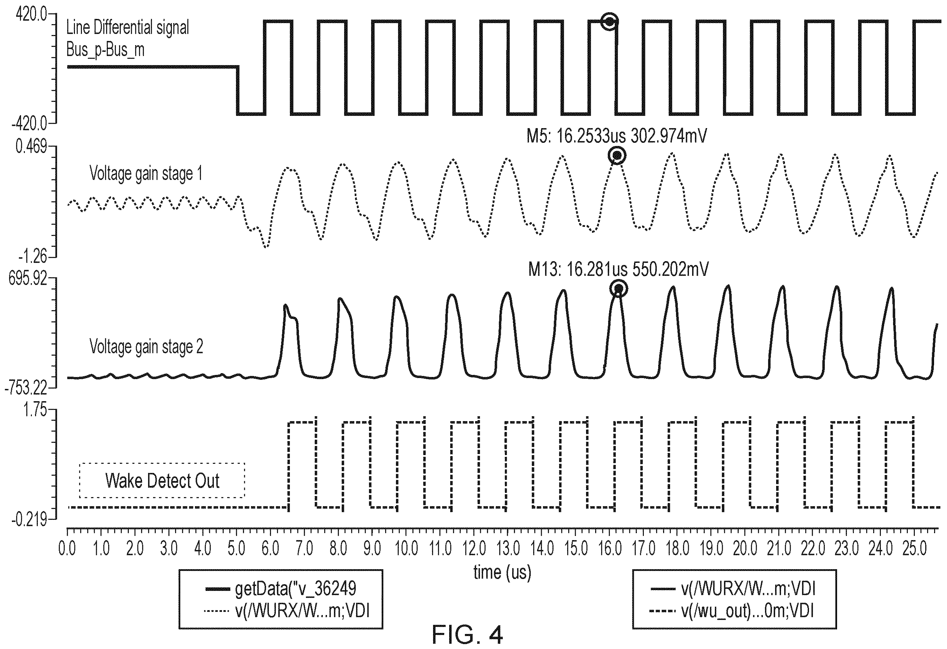

Figure 4 shows another plot of signals during operation of the circuit of Figure 1. The upper plot shows the differential signal is present on the bus. The second plot shows the output of the first gain stage (at the first and second output terminals 111, 112 in Figure 1; i.e., the voltage gain across resistors RG). Here it can be seen that the RF common mode is completely rejected and only the differential component is visible and with a very good gain. The third plot shows the output waveform from the preamplifier 143 in Figure 1, which further gains the signal. The output signal from the comparator is shown in the lower plot. It can be seen that the comparator detects the preamplifier output and comfortably makes a detection as the final wake-detect output.

In summary, the cross-coupled architecture described herein can provide significant benefits in current consumption, mismatch performance and transient DPI performance at low supply.

One or more of the examples disclosed herein can be considered as a low power wake up receiver, which are particularly suitable for automotive transceivers such as those that use CAN, CANXL or 10BASE-T1S ethernet. Advantageously, examples of the present disclosure relate to a low supply wake-up receiver circuit that is used in a low power mode of a transceiver while providing excellent DPI, ISO compliance. Such examples include a cross-coupled common gate differential amplifier as an input stage of a WURX for small signal processing and rejection of RF common mode at low supply.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A differential input receiver for detecting wake-up signalling in a differential communication system, the receiver comprising:

a positive input signal terminal for connecting to a positive bus of the differential communication system;

a negative input signal terminal, for connecting to a negative bus of the differential communication system;

a first output terminal;

a second output terminal;

a first current source;

a second current source;

a first diode connected field-effect-transistor, FET, having a source, a drain and a gate, wherein

> the source of the first diode connected FET is connected to the positive input signal terminal,
> the drain of the first diode connected FET is connected to the first current source, and
> the gate of the first diode connected FET is connected to the first current source;

a second diode connected FET, having a source, a drain and a gate, wherein

> the source of the second diode connected FET is connected to the negative input signal terminal,
> the drain of the second diode connected FET is connected to the second current source, and
> the gate of the second diode connected FET is connected to the second current source;

a first cross differential FET, having a source, a drain and a gate, wherein

> the source of the first cross differential FET is connected to the negative input signal terminal, and
> the drain of the first cross differential FET is connected to the first output terminal,

the gate of the first cross differential FET is connected to the gate of the first diode connected FET; and

a second cross differential FET, having a source, a drain and a gate, wherein

> the source of the second cross differential FET is connected to the positive input signal terminal, and
> the drain of the second cross differential FET is connected to the second output terminal,

the gate of the second cross differential FET is connected to the gate of the second diode connected FET.

2. The differential input receiver of claim 1, wherein:

> the first diode connected FET is an n-type metal-oxide-semiconductor, NMOS, FET;
> the second diode connected FET is an NMOS FET;
> the first cross differential FET is an NMOS FET; and
> the second cross differential FET is an NMOS FET.

3. The differential input receiver of any preceding claim, further comprising:

> a first upper voltage divider resistor with a first terminal connected to the positive input signal terminal and a second terminal connected to the source of the second cross differential FET and the source of the first diode connected FET;
> a first lower voltage divider resistor with a first terminal connected to the second terminal of the first upper voltage divider resistor and a second terminal connected to a ground terminal;
> a second upper voltage divider resistor with a first terminal connected to the negative input signal terminal and a second terminal connected to the source of the first cross differential FET and the source of the second diode connected FET; and
> a second lower voltage divider resistor with a first terminal connected to the second terminal of the second upper voltage divider resistor and a second terminal connected to the ground terminal.

4. The differential input receiver of claim 3, wherein:

> the first upper voltage divider resistor has a resistance greater than the resistance of the first lower voltage divider resistor; and
> the second upper voltage divider resistor has a resistance much greater than the resistance of the second lower voltage divider resistor.

**5.** The differential input receiver of claim 3 or claim 4, further comprising:

a first capacitor having a first plate and a second plate, wherein: the first plate is connected to the second terminal of the first upper voltage divider resistor; and the second plate is connected to the ground terminal; and a second capacitor having a first plate and a second plate, wherein: the first plate is connected to the second terminal of the second upper voltage divider resistor; and the second plate is connected to the ground terminal.

**6.** The differential input receiver of any one of claims 3 to 5, further comprising a threshold resistor connected between either:

i) the second terminal of the first upper voltage divider resistor, and ii) the source of the first diode connected FET and the source of the second cross differential FET; or
i) the second terminal of the second upper voltage divider resistor, and ii) the source of the second diode connected FET and the source of the first cross differential FET.

**7.** The differential input receiver of claim 6, further comprising a threshold setting current source configured to provide a current to a node between either:

the second terminal of the first upper voltage divider resistor and the first threshold resistor, if
the first threshold resistor is connected between the second terminal of the first upper voltage divider resistor and the source of the first diode connected FET and the source of the second cross differential FET; or
the first threshold resistor and the source of the first cross differential FET and the source of the second diode connected FET, if
the first threshold resistor is connected between the second terminal of the second upper voltage divider resistor and the source of the second diode connected FET and the source of the first cross differential FET.

**8.** The differential input receiver of any one of claims 3 to 5, further comprising:

a first threshold resistor connected between: i) the second terminal of the first upper voltage divider resistor; and ii) the source of the first diode connected FET and the source of the second cross differential FET;
a second threshold resistor connected between: i) the second terminal of the second upper voltage divider resistor; and ii) the source of the second diode connected FET and the source of the first cross differential FET;
a first threshold setting current source configured to provide a current to a node between the first upper voltage divider resistor and the first threshold resistor; and
a second threshold setting current source configured to provide a current to a node between the second threshold resistor and the and the source of the second diode connected FET.

**9.** The differential input receiver of any preceding claim, further comprising:

a cascode voltage source;
a first cascode FET having a source, gate and drain, wherein:

the source of the first cascode FET is connected to the drain of the first cross differential FET,
the drain of the first cascode FET is connected to the first output terminal, and
the gate of the first cascode FET is connected to a first cascode voltage source; and

a second cascode FET having a source, gate and drain, wherein:

the source of the second cascode FET is connected to the drain of the second cross differential FET,
the drain of the second cascode FET is connected to the second output terminal, and
the gate of the second cascode FET is connected to a second cascode voltage source.

**10.** The differential input receiver of claim 9, wherein:

the first cascode FET is an NMOS FET; and
the second cascode FET is an NMOS FET.

**11.** The differential input receiver of any preceding claim, further comprising:

a first folded cascode current source ;
a second folded cascode current source;
a folded cascode voltage source;
a first folded cascode FET and a second folded cascode FET, each having a source, drain and a gate, wherein:

the source of the first folded cascode FET is connected to: i) the drain of the second cross differential FET; and ii) the first folded cascode current source;
the drain of the first folded cascode FET is connected to the second output terminal;
the gate of the first folded cascode FET is connected to the gate of the first folded cascode FET;
the source of the second folded cascode FET is connected to: i) the drain of the first cross differential FET; and ii) the second folded cascode current source;

the drain of the second folded cascode FET is connected to the first output terminal.

12. The differential input receiver of claim 11, further comprising:

a first sink FET, having a source, drain and a gate, wherein:

the source of the first sink FET is connected to a ground terminal; and
the drain of the first sink FET is connected to the second output terminal and the drain of the third cascode FET;

a second sink FET, having a source, drain and a gate, wherein:

the source of the second sink FET is connected to the ground terminal;
the drain of the second sink FET is connected to the first output terminal and the drain of the fourth cascode FET; and
the gate of the second sink FET is connected to the gate of the first sink FET.

a first differential gain resistor connected between: i) the second output terminal; and ii) the gate of the second sink FET and the gate of the first sink FET; and
a second differential gain resistor connected between: i) the first output terminal; and ii) the gate of the second sink FET and the gate of the first sink FET.

13. The differential input receiver of claim 12, wherein:

the first folded cascode FET is a PMOS FET;
the second folded cascode FET is a PMOS FET;
the first sink FET is an NMOS FET; and
the second sink FET is an NMOS FET.

14. A wake-up receiver comprising:

the differential input receiver of any preceding claim;
a wake-up receiver output terminal; and
a comparator comprising a first input terminal, a second input terminal and an output terminal, wherein:

the first input terminal of the comparator is connected to the second output terminal of the differential input receiver,
the second input terminal of the comparator is connected to the first output terminal of the differential input receiver, and
the output terminal of the comparator is connected to the wake-up receiver output terminal.

15. The wake-up receiver of claim 14, further comprising an additional gain stage comprising:

a first input terminal,
a second input terminal,
a first output terminal, and

a second output terminal, wherein:

the first input terminal of the additional gain stage is connected to the second output terminal of the differential input receiver,

the second input terminal of the additional gain stage is connected to the first output terminal of the differential input receiver,

the first output terminal of the additional gain stage is connected to the first input terminal of the comparator, and

the second output terminal of the additional gain stage is connected to the second input terminal of the comparator.

Figure 1

FIG. 1

FIG. 1 (Continued)

EP 4 568 196 A1

FIG. 2

FIG. 2 (Continued)

FIG. 3

EP 4 568 196 A1

FIG. 4

Europäisches
Patentamt

European
Patent Office

Office européen
des brevets

**EUROPEAN SEARCH REPORT**

Application Number

EP 24 15 6391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2004/119517 A1 (PAULETTI TIMOTHY P [US] ET AL) 24 June 2004 (2004-06-24) <br> * paragraph [0005] - paragraph [0006] * <br> * paragraph [0013] - paragraph [0023] * <br> * figure 2 * | 1-15 | INV. <br> H04L25/02 <br> H03K3/00 <br> H04J3/12 <br> H04L12/40 |
| A | US 2016/374021 A1 (ALPMAN ERKAN [US] ET AL) 22 December 2016 (2016-12-22) <br> * paragraph [0020] * <br> * paragraph [0022] * <br> * paragraph [0090] - paragraph [0094] * <br> * figures 8-10 * | 1-15 | |
| A | US 2011/267110 A1 (MCLEOD SCOTT C [US]) 3 November 2011 (2011-11-03) <br> * paragraph [0003] * <br> * paragraph [0008] - paragraph [0010] * <br> * paragraph [0028] - paragraph [0035] * | 1-15 | |

TECHNICAL FIELDS
SEARCHED      (IPC)

H04L
H03K
H04J

The present search report has been drawn up for all claims

| Place of search | Date of completion of the search | Examiner |
|---|---|---|
| Munich | 26 June 2024 | Palacián Lisa, Marta |

EPO FORM 1503 03.82 (P04C01)

## ANNEX TO THE EUROPEAN SEARCH REPORT
## ON EUROPEAN PATENT APPLICATION NO.

EP 24 15 6391

This annex lists the patent family members relating to the patent documents cited in the above-mentioned European search report.
The members are as contained in the European Patent Office EDP file on
The European Patent Office is in no way liable for these particulars which are merely given for the purpose of information.

26-06-2024

| Patent document cited in search report | Publication date | Patent family member(s) | | Publication date |
|---|---|---|---|---|
| US 2004119517 A1 | 24-06-2004 | NONE | | |
| US 2016374021 A1 | 22-12-2016 | NONE | | |
| US 2011267110 A1 | 03-11-2011 | EP | 2272163 A1 | 12-01-2011 |
| | | JP | 5276710 B2 | 28-08-2013 |
| | | JP | 2011515953 A | 19-05-2011 |
| | | KR | 20100127833 A | 06-12-2010 |
| | | US | 2009237117 A1 | 24-09-2009 |
| | | US | 2011267110 A1 | 03-11-2011 |
| | | WO | 2009117394 A1 | 24-09-2009 |

EPO FORM P0459